Europäisches Patentamt

European Patent Office

Office européen des brevets

(19)

(11) Numéro de publication: **0 492 654 A1**

(12) **DEMANDE DE BREVET EUROPEEN**

(21) Numéro de dépôt: **91122303.0**

(22) Date de dépôt: **27.12.91**

(51) Int. Cl.⁵: **H01L 21/48**

(30) Priorité: **27.12.90 FR 9016318**

(43) Date de publication de la demande:
**01.07.92 Bulletin 92/27**

(84) Etats contractants désignés:
**AT BE CH DE ES FR GB IT LI NL SE**

(71) Demandeur: **ALCATEL CIT**
**12 Rue de la Baume**
**F-75008 Paris(FR)**

(72) Inventeur: **Trentesaux, Thierry**

22, avenue de la Mandrille
F-45610 Chaingy(FR)
Inventeur: **Martin, Yves**
52, rue de Coutes
F-45140 Ingre(FR)
Inventeur: **Daniel, Christian**
46, rue des Beamonts
F-45000 Orleans(FR)

(74) Mandataire: **Weinmiller, Jürgen et al**
**Lennéstrasse 9 Postfach 24**
**W-8133 Feldafing(DE)**

(54) **Procédé et dispositif d'étamage des plages étamables d'un boîtier de composant électronique.**

(57) Ce procédé d'étamage de plages étamables d'un boîtier de composant électronique (10), comporte une première étape au cours de laquelle un matériau métallique d'apport (18), à l'état liquide, est amené sur lesdites plages étamables (1,4), et une étape suivante au cours de laquelle, alors que ledit matériau (18) ainsi amené est encore à l'état liquide, est appliqué au boîtier (10) au moins un cycle d'oscillations, autour d'une position d'équilibre, destinées à créer des déplacements successifs et opposés des masses dudit matériau le long desdites plages (1,4), en vue d'une répartition uniforme dudit matériau sur lesdites plages (1,4).

FIG.7

FIG. 2

La présente invention concerne un procédé et un dispositif d'étamage de plages étamables d'un boîtier de composant électronique tel qu'un circuit intégré par exemple, en vue de son montage en surface dans un circuit hybride.

Un boîtier de circuit intégré, pour montage en surface dans un circuit hybride, présente des plages étamables permettant son montage par brasage de ses plages étamables à des plages étamables prévues en correspondance sur le substrat de ce circuit hybride, l'étamage de ces plages permettant un apport de matériau métallique nécessaire à l'opération ultérieure de brasage. Ce matériau métallique d'apport, encore appelé brasure, est généralement constitué d'un alliage eutectique étain-plomb.

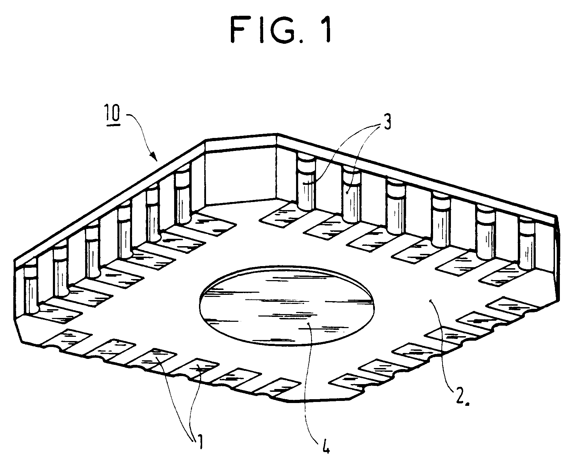

Un boîtier de circuit intégré destiné à être monté en surface dans un circuit hybride comporte ainsi, comme rappelé sur la figure 1, des plages étamables telles que 1, dites ici de connexion, qui sont situées à la périphérie de la face inférieure 2 du boîtier, lequel a en général une forme sensiblement parallélépipèdique et de faible épaisseur, et qui prolongent sur cette face inférieure les plots extérieurs de connexion tels que 3 accessibles autrement par les faces latérales de ce boîtier. Ces connexions sont raccordées à la puce du circuit intégré par des traversées aboutissant à l'intérieur du boîtier à des plots de connexion de ladite puce.

Certains boîtiers peuvent en outre présenter une plage étamable telle que 4, dite ici d'échange thermique et/ou de fixation mécanique, pour les échanges thermiques du circuit intégré avec l'extérieur et/ou pour la fixation mécanique du boîtier au substrat du circuit hybride.

Comme rappelé sur la figure 1, les plots extérieurs de connexion ont, dans leur partie située dans le prolongement des plages je connexion, une forme concave permettant la constitution de réserves de brasure apportée sur les plages de connexion au cours de l'opération d'étamage de ces plages, permettant à leur tour, après brasage sur le substrat, d'obtenir des congés de brasure servant notamment au contrôle visuel des connexions extérieures de ce boîtier.

L'étamage des plages étamables d'un boîtier de circuit intégré comporte en général une première étape au cours de laquelle une certaine quantité de brasure, à l'état liquide, est amenée sur lesdites plages étamables, généralement en quantité supérieure à celle nécessaire, par des techniques telles que le trempage, et une étape suivante au cours de laquelle, ladite brasure étant encore à l'état liquide, on procède alors à l'élimination de la quantité excédentaire de cette brasure.

Diverses méthodes sont connues pour effectuer cette dernière étape.

Une première méthode consiste simplement à faire subir un choc manuel au boîtier. On conçoit cependant que cette méthode nécessite un apprentissage délicat de l'opérateur et qu'elle est difficilement reproductible car non automatisée. Par ailleurs, cette méthode ne permet pas d'obtenir une épaisseur de brasure uniforme sur toutes les plages étamables du boîtier, et un remplissage suffisant des réserves des connexions périphériques, ceux-ci étant en effet fonction de l'orientation donnée à ce boîtier au cours de ce choc.

Une deuxième méthode consiste à faire subir un basculement au boîtier, par exemple en le faisant sortir du bain de brasure tangentiellement à la surface de ce bain. Cette méthode a également pour inconvénient de ne pas permettre d'obtenir une épaisseur de brasure uniforme sur les plages étamables du boîtier, et un remplissage suffisant de toutes les réserves, ceux-ci étant en effet fonction de l'orientation donnée à ce boîtier au cours de cette opération de basculement.

Une troisième méthode, décrite par exemple dans le brevet français n° 2 570 220, consiste à faire subir au boîtier, à la sortie du bain, une rotation autour d'un axe perpendiculaire à ses faces inférieure et supérieure, en vue d'éliminer la quantité excédentaire de brasure par centrifugation. Cette méthode a pour principal inconvénient d'être mal adaptée à des boîtiers munis des deux types de plages étamables rappelés ci-dessus, car elle ne permet pas d'obtenir à la fois un dépôt de faible épaisseur sur la plage centrale d'échange thermique et/ou de fixation mécanique, proche de l'axe de rotation, et une quantité de brasure suffisante dans les réserves périphériques des plages de connexion, où l'effet de la force centrifuge est maximal.

Or, afin d'éviter l'apparition de défauts de soudure après brasage sur le substrat du circuit hybride, par refusion de la brasure ainsi apportée au cours de l'opération d'étamage, il est essentiel que l'épaisseur de ladite brasure sur lesdites plages étamables du boîtier soit faible et aussi uniforme que possible et que la quantité de brasure dans lesdites réserves soit juste suffisante.

La présente invention a pour objet un procédé d'étamage comportant une opération de répartition de ladite brasure sur les plages étamables, en vue d'obtenir à la fois une épaisseur de brasure qui soit uniforme sur ces plages étamables et une quantité de brasure qui soit suffisante dans les réserves périphériques.

La présente invention a pour objet un procédé d'étamage de plages étamables d'un boîtier de composant électronique, comportant une première étape au cours de laquelle un matériau métallique d'apport à l'état liquide est amené sur lesdites plages étamables, essentiellement caractérisé en ce qu'il comporte une étape suivante au cours de laquelle, alors que ledit matériau ainsi amené est encore à l'état liquide, est appliqué au boîtier au moins un cycle d'oscillations, autour d'une position d'équilibre, destinées à créer des déplacements successifs et opposés des masses dudit matériau le long desdites plages, en vue d'une répartition uniforme dudit matériau sur lesdites plages.

La présente invention a également pour objet un procédé d'étamage dans lequel ladite opération de répartition est en outre déterminée pour assurer une élimination de la quantité excédentaire dudit matériau métallique d'apport, en vue d'obtenir une épaisseur de brasure qui soit à la fois faible et uniforme sur les plages étamables et juste suffisante dans les réserves périphériques.

La présente invention a ainsi pour objet un procédé d'étamage, essentiellement caractérisé en ce que ledit matériau étant amené en quantité supérieure à celle nécessaire, l'amplitude des premières oscillations du cycle est déterminée de façon à provoquer une élimination de la quantité de matériau métallique excédentaire.

La présente invention a également pour objet un dispositif pour une mise en oeuvre automatisée, et donc parfaitement reproductible, de ce procédé.

D'autres objets et caractéristiques de la présente invention apparaîtront à la lecture de la description suivante d'un exemple de réalisation, faite en relation avec les dessins ci-annexés dans lesquels, outre la figure 1 rappelant les divers types de plages étamables d'un boîtier de circuit intégré et décrits ci-dessus :

- les figures 2 et 3 sont des schémas montrant un dispositif possible pour la mise en oeuvre du procédé d'étamage suivant l'invention, la figure 2 étant une vue d'ensemble, schématisée et simplifiée, montrant la constitution générale de ce dispositif et la figure 3 une vue plus détaillée des éléments de ce dispositif assurant plus précisément ladite répartition et éventuellement ladite élimination,

- les figures 4 et 5 sont des diagrammes représentant respectivement la forme des impulsions d'alimentation des électro-aimants dans un dispositif tel que représenté sur les figures 2 et 3 et la forme correspondante des cycles d'oscillations amorties subies par le boîtier,

- la figure 6 est une vue de dessous (par référence aux vues des figures 2 et 3) montrant une disposition avantageuse du boîtier par rapport à la direction de déplacement des armatures mobiles des électro-aimants,

- la figure 7 est une vue montrant de façon simplifiée, une utilisation particulière des éléments représentés sur la figure 3 pour la réalisation de l'opération de trempage par laquelle le matériau métallique d'apport est amené sur les plages étamables.

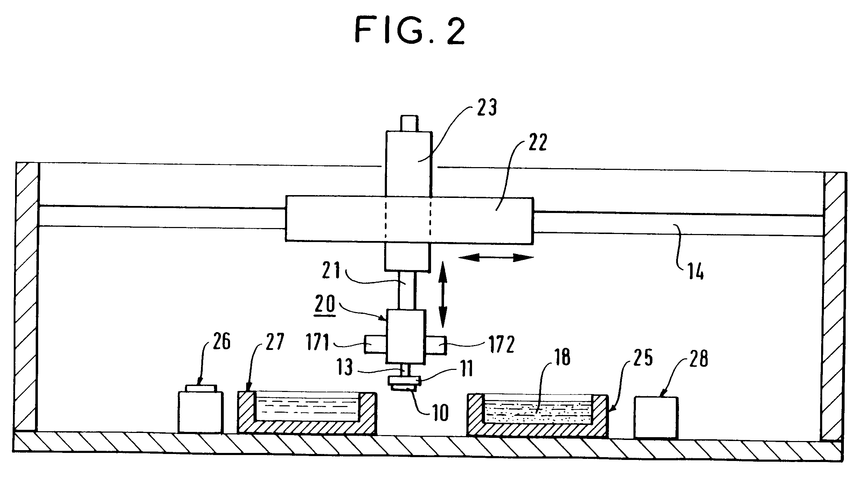

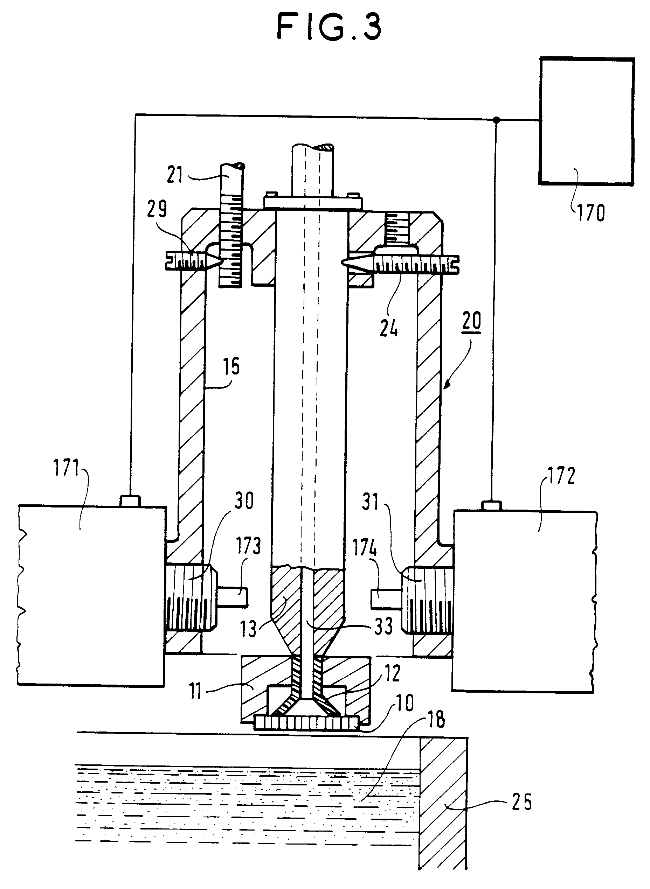

Sur la figure 2 on distingue un boîtier de circuit intégré 10 qui est maintenu par un support de préhension 11, lequel est fixé à un barreau 13, ce dernier étant lui-même supporté par un ensemble 20 appelé tête, susceptible d'agir, comme décrit ultérieurement, au moyen de deux électro-aimants 171, 172 solidaires de cette tête, sur le barreau 13, et donc sur le support de préhension 11 et sur le boîtier 10, pour assurer ladite répartition et éventuellement ladite élimination, le barreau 13 étant, en dehors de toute action des électro-aimants, maintenu par cette tête dans une position d'équilibre verticale. Tous ces éléments apparaissent de façon plus détaillée sur la figure 3.

La tête 20 est fixée à un support horizontal 14 par une tige verticale 21 mobile suivant les directions horizontale et verticale, comme indiqué par des flèches sur la figure 2, grâce à des chariots 22 et 23 de déplacement suivant ces directions et qui sont commandés par des moteurs pas à pas.

Cette mobilité de la tête suivant les directions horizontale et verticale permet, non seulement le chargement du boîtier au poste référencé 26, mais ensuite, son passage par différents postes de traitement, tels que, outre le poste d'étamage considéré ici, et référencé 25, les postes de fluxage, et déchargement, référencés respectivement 27, 28. La mobilité de la tête 20 suivant la direction verticale permet donc de plonger au moins en partie le boîtier 10 non seulement dans le bain de fluxage mais bien évidemment dans le bain 18 d'alliage liquide, ou de l'en retirer.

Sur la figure 3 on distingue le boîtier de circuit intégré 10, disposé horizontalement, avec en l'occurence sa paroi inférieure tournée vers le bas, et maintenu dans cette position par le support de préhension 11 permettant de le saisir, en l'occurence par sa paroi supérieure, à l'aide d'une ventouse 12 logée à l'intérieur dudit support, et qui applique sur cette paroi supérieure une aspiration fournie par une pompe à vide (non représentée) à laquelle la ventouse 12 est reliée par l'intermédiaire d'un conduit 33 aménagé dans le barreau 13. Le support de préhension 11 est fixé à l'extrémité basse dudit barreau 13.

La tête 20 est formée d'une sorte de cylindre creux 15 aménagé pour maintenir dans sa partie supérieure horizontale l'extrémité haute du barreau 13, et sur sa paroi verticale, de préférence à l'opposé l'un de l'autre et à une même hauteur, les deux électro-aimants 171, 172 qui sont avantageusement identiques et qui ont chacun leur armature mobile équipée d'un poussoir, respectivement 173, 174, disposés horizontalement et susceptibles de venir heurter le barreau 13 lorsque ces électro-aimants sont alimentés convenablement par un dispositif d'alimentation 170 en l'occurence commun à ces deux électro-aimants.

Le barreau 13 est fixé à la partie supérieure horizontale de la tête 20 par des moyens de blocage, par exemple par vis, représentés de façon schématique en 24 sur la figure 3.

La tige 21 est de même fixée à la partie supérieure de la tête 20 par des moyens de blocage, par exemple par vis, représentés de façon schématique en 29 sur la figure 3.

Les électro-aimants 171, 172 sont respectivement fixés à la paroi verticale de la tête 20 par des moyens d'assemblage constitués par une sorte de canon fileté 30, 31, au travers duquel coulisse leur poussoir, qui vient coopérer par vissage dans un trou aménagé correspondamment dans ladite paroi.

On notera qu'une électrode de détection de niveau du bain d'alliage ainsi qu'une raclette de nettoyage de la surface du bain, non représentées, sont avantageusement prévues et fixées à la partie inférieure de la paroi verticale de la tête 20.

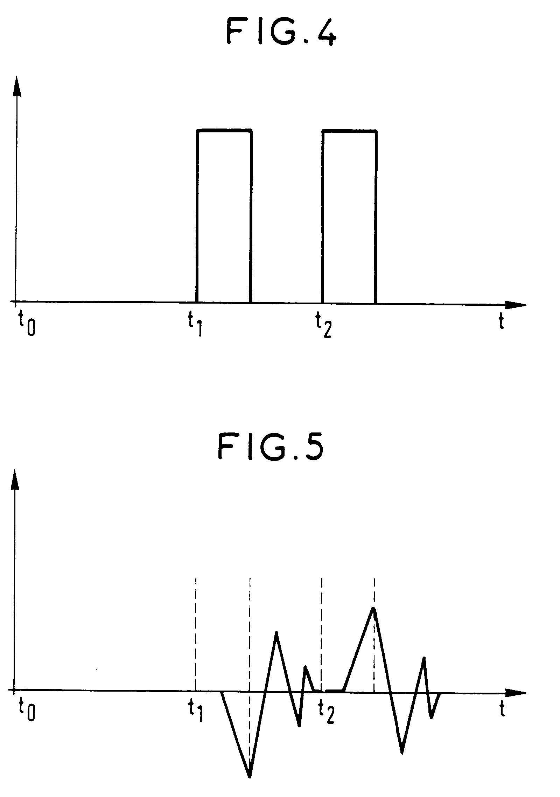

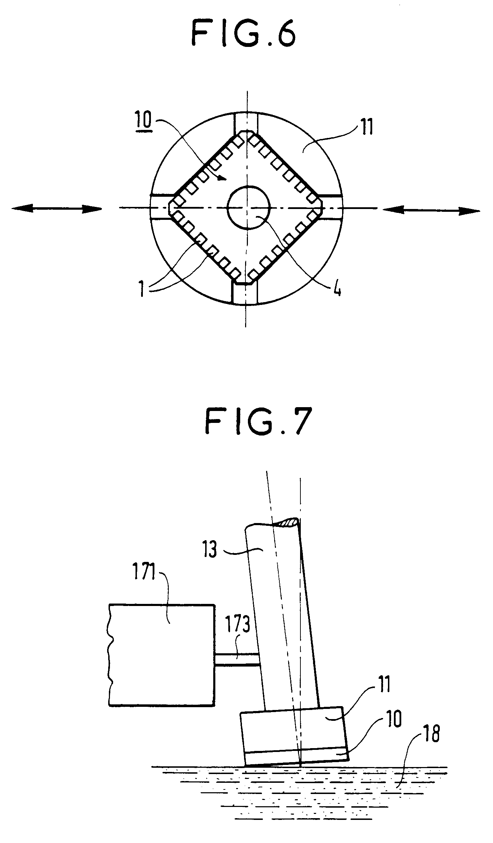

L'un des électro-aimants, l'électro-aimant 171 par exemple, est alimenté par un signal présentant, à un instant t1 donné suivant l'instant to de sortie du boîtier 10 du bain d'alliage liquide, une impulsion I1 telle que celle représentée sur la figure 4. Le poussoir 173 de l'armature mobile de cet électro-aimant vient alors heurter le barreau 13, qui est avantageusement en un matériau tel que le polyuréthane permettant d'amortir ce choc et de le retransmettre, ainsi amorti, au support de préhension 11 et donc au boîtier 10 qui est alors soumis à un cycle d'oscillations amorties autour de sa position d'équilibre verticale, comme montré sur la figure 5.

Outre le matériau dans lequel est réalisé le barreau 13, contribuent également à cet amortissement la fixation rigide du barreau 13 à la tête 20 et le poids de l'ensemble formé par le barreau 13, le support de préhension 11 et la ventouse 12. L'amplitude des premières oscillations de ce cycle d'oscillations amorties, notamment de la première d'entre elles, peut alors être dimensionnée de façon suffisamment importante pour provoquer une élimination de la quantité d'alliage liquide excédentaire.

Dans le cas où une telle élimination ne serait pas nécessaire, ou serait obtenue différemment, un amortissement aussi important n'aurait pas lieu d'être et le cycle d'oscillations appliqué au boîtier permettrait alors simplement d'obtenir, par des déplacements successifs et opposés des masses d'alliage liquide le long des plages étamables, une répartition uniforme de cet alliage sur ces plages ainsi qu'une quantité suffisante de cet alliage dans les réserves périphériqes.

Pour une meilleure uniformité de répartition, et particulièrement dans le cas de l'application au boîtier d'un cycle d'oscillations amorties comme envisagé plus haut, un deuxième cycle d'oscillations amorties est avantageusement appliqué ensuite en alimentant, après retour du boîtier à sa position d'équilibre, et à un instant t2, l'autre électro-aimant, en l'occurence l'électro-aimant 172, par une impulsion I2 d'amplitude avantageusement identique à celle de l'impulsion I1 appliquée précédemment à l'électro-aimant 171. L'impulsion I2 est également représentée sur la figure 4, et le cycle correspondant d'oscillations amorties est également représenté sur la figure 5, cette représentation mettant en évidence le fait que des déplacements successifs et opposés, ou strictement opposés dans le cas d'impulsions I1 et I2 d'amplitudes identiques, des masses d'alliage le long des plages étamables sont obtenues pour des oscillations de même rang de ces deux cycles.

L'amplitude des premières oscillations de ces deux cycles est alors déterminée de façon à ne pas provoquer d'élimination d'alliage au-delà de la quantité excédentaire. Suivant le type d'application envisagé, plusieurs couples de tels cycles d'oscillations amorties pourraient ainsi être appliqués successivement au boîtier.

Les paramètres tels que l'amplitude des impulsions de commande des électro-aimants, leur durée, leur instant d'apparition l'une par rapport à l'autre ainsi que par rapport à l'instant to de sortie du bain, sont déterminés en fonction du type d'application envisagé, et notamment en fonction du type de boîtier et du type d'alliage utilisés.

Après application de ce ou de ces cycles d'oscillations, le support de préhension reste au-dessus du bain pour respecter un certain palier de température, avant refroidissement.

Comme représenté sur la figure 6, le boîtier 10 est avantageusement maintenu par le support de préhension 11 suivant une orientation telle que les chocs reçus sont, dans le cas d'un boîtier de forme sensiblement parallélépipèdique, appliqués suivant l'une des diagonales d'une section de ce parallélépipède, ce qui permet, par symétrie, d'obtenir une répartition plus homogène du matériau métallique à l'intérieur des plages étamables.

On notera que l'amplitude de déplacement du boîtier au cours de ces oscillations, et donc l'amplitude de déplacement qui en résulte pour les masses d'alliage métallique le long des plages étamables de ce boîtier, étant en pratique extrêmement faibles, le boîtier conserve sa position horizontale au cours de ces oscillations, de sorte que ladite opération d'élimination ne perturbe pas ladite opération de répartition, et vice-versa.

Les électro-aimants du dispositif suivant l'invention peuvent en outre être avantageusement utilisés pour réaliser, lors de l'opération préalable de trempage, un accostage du boîtier en évitant d'emprisonner une bulle d'air entre ce boîtier et la surface du bain.

Ceci est simplement obtenu par une excitation continue de l'un des électro-aimants, l'électro-aimant 171 par exemple comme représenté sur la figure 7, qui provoque alors une légère inclinaison du boîtier par rapport à la surface, horizontale, du bain, au moment de l'accostage.

Le boîtier est ensuite remis en position horizontale par relâchement de l'excitation de cet électro-aimant.

## Revendications

1. Procédé d'étamage de plages étamables d'un boîtier de composant électronique, comportant une première étape au cours de laquelle un matériau métallique d'apport, à l'état liquide, est amené sur lesdites plages étamables, caractérisé en ce qu'il comporte une étape suivante au cours de laquelle, alors que ledit matériau ainsi amené est encore à l'état liquide, est appliqué au boîtier au moins un cycle d'oscillations, autour d'une position d'équilibre, destinées à créer des déplacements successifs et opposés des masses dudit matériau le long desdites plages, en vue d'une répartition uniforme dudit matériau sur lesdites plages.

2. Procédé selon la revendication 1, caractérisé en ce que, ledit matériau étant amené en quantité supérieure à celle nécessaire, l'amplitude des premières oscillations de ce cycle est déterminée de façon à provoquer une élimination de la quantité de matériau excédentaire.

3. Procédé selon l'une des revendications 1 et 2, caractérisé en ce qu'il comporte l'application au boîtier d'au moins un couple de deux cycles d'oscillations amorties destinés à créer des déplacements opposés pour des oscillations de même rang des cycles d'un couple.

4. Procédé selon la revendication 3, caractérisé en ce que les deux cycles d'un couple sont séparés d'une durée au moins égale au temps de retour à ladite position d'équilibre.

5. Procédé selon l'une des revendications 1 à 4, caractérisé en ce que ledit boîtier est disposé horizontalement au cours de ladite application d'au moins un cycle d'oscillations, avec sa face recouverte desdites plages étamables orientée vers le bas.

6. Procédé selon la revendication 5, caractérisé en ce que, ledit boîtier ayant une forme sensiblement parallélépipèdique, le ou les cycles d'oscillations sont appliqués suivant la direction de l'une des diagonales d'une section de ce parallélépipède.

7. Dispositif pour la mise en oeuvre du procédé suivant l'une des revendications 1 à 6, caractérisé en ce qu'il comporte des moyens pour appliquer au boîtier au moins un cycle d'oscillations, autour d'une position d'équilibre, destinées à créer des déplacements successifs et opposés des masses dudit matériau le long desdites plages, en vue d'une répartition uniforme dudit matériau sur lesdites plages.

8. Dispositif selon la revendication 7, caractérisé en ce que lesdits moyens comportent au moins un électro-aimant (171, 172) monté avec son armature mobile équipé d'un poussoir (173, 174) horizontale et susceptible de venir heurter un barreau vertical (13) ayant son extrémité haute fixée à la partie supérieure horizontale d'un ensemble (20) appelé tête et son extrémité basse munie de moyens de maintien du boîtier (10) suivant une position horizontale.

9. Dispositif selon la revendication 8, caractérisé en ce que lesdits moyens d'application d'au moins un cycle d'oscillations comportent deux électro-aimants (171, 172) disposés de part et d'autre dudit barreau.

10. Dispositif selon l'une des revendications 8 et 9, caractérisé en ce que lesdits moyens de maintien comportent un support de préhension (11) munie intérieurement d'une ventouse (12) reliée à une pompe à vide.

11. Procédé d'utilisation du dispositif selon la revendication 8, caractérisé en ce que, ladite première étape comportant un trempage dans un bain dudit matériau, il comporte une excitation continue dudit électro-aimant en vue d'incliner le boîtier par rapport à la surface du bain au moment de l'accostage.

# FIG. 1

# FIG. 2

EP 0 492 654 A1

# FIG.3

# FIG.4

$$t_0 \qquad t_1 \qquad t_2 \qquad t$$

# FIG.5

$$t_0 \qquad t_1 \qquad t_2 \qquad t$$

# FIG.6

# FIG.7

Office européen
des brevets

**RAPPORT DE RECHERCHE EUROPEENNE**

Numero de la demande

EP    91 12 2303

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | PATENT ABSTRACTS OF JAPAN vol. 003, no. 109 (C-058)12 Septembre 1979 & JP-A-54 089 957 ( FUJITSU LTD ) 17 Juillet 1979 * abrégé * | 1,2,5,7, 11 | H01L21/48 |
| A | --- | 8 | |
| X | PATENT ABSTRACTS OF JAPAN vol. 007, no. 182 (E-192)11 Août 1983 & JP-A-58 086 753 ( HITACHI ) 24 Mai 1983 * abrégé * --- | 1,2,5,7, 11 | |
| X | PATENT ABSTRACTS OF JAPAN vol. 12, no. 325 (M-737)5 Septembre 1988 & JP-A-63 093 468 ( FUJI ELECTRIC CO LTD ) 23 Avril 1988 * abrégé * --- | 1,2,7,11 | |
| D,A | FR-A-2 570 220 (MATRA) * le document en entier * | | |

-----

**DOMAINES TECHNIQUES RECHERCHES (Int. Cl.5)**

H01L

Le présent rapport a été établi pour toutes les revendications

| Lieu de la recherche | Date d'achèvement de la recherche | Examinateur |
|---|---|---|
| LA HAYE | 15 AVRIL 1992 | ZEISLER P. |

**CATEGORIE DES DOCUMENTS CITES**

X : particulièrement pertinent à lui seul
Y : particulièrement pertinent en combinaison avec un
     autre document de la même catégorie
A : arrière-plan technologique
O : divulgation non-écrite
P : document intercalaire

T : théorie ou principe à la base de l'invention
E : document de brevet antérieur, mais publié à la
     date de dépôt ou après cette date
D : cité dans la demande
L : cité pour d'autres raisons

& : membre de la même famille, document correspondant

EPO FORM 1503 03.82 (P0402)